Europäisches Patentamt

(19) European Patent Office (11) Publication number: **0 135 925**

Office européen des brevets **B1**

(12) **EUROPEAN PATENT SPECIFICATION**

(45) Date of publication of patent specification: **07.01.87** (51) Int. Cl.⁴: **C 09 D 3/00,** G 02 B 1/10,
C 08 F 283/00

(21) Application number: **84111387.1**

(22) Date of filing: **25.09.84**

(54) Photo-settable, light-shielding coating composition.

(30) Priority: **27.09.83 JP 178509/83**

(43) Date of publication of application:
**03.04.85 Bulletin 85/14**

(45) Publication of the grant of the patent:
**07.01.87 Bulletin 87/02**

(84) Designated Contracting States:
**DE FR GB**

(56) References cited:
**EP-A-0 050 996
FR-A-2 144 802
GB-A-2 030 584
US-A-4 384 026**

(73) Proprietor: **Matsushita Electric Industrial Co.,
Ltd.
1006, Oaza Kadoma
Kadoma-shi Osaka-fu, 571 (JP)**

(72) Inventor: **Inoue, Takao
28-7, Yamadaikehigashimachi
Hirakata-shi Osaka-fu (JP)**
Inventor: **Matsuo, Takahiro
3-18, Nakamiyahigashino-cho
Hirakata-shi Osaka-fu (JP)**

(74) Representative: **Eisenführ & Speiser
Martinistrasse 24
D-2800 Bremen 1 (DE)**

**Description**

Background of the Invention

The present invention generally relates to a photo-settable, light-shielding coating composition and, more particularly, to the composition utilizeable to form a light shield layer on a peripheral area of an optical lens, particularly a plastics lens, used in binoculars, cameras, video projectors or like optical devices, for minimizing the irregular internal reflection of light and also screening unwanted external light.

In order to form a light shield coating on a peripheral area of a glass lens, either an Indian ink containing a volatile solvent or a black-colored thermosettable paint consisting of a kneaded mixture of a main ingredient, a hardening agent and a carbon powder has long been utilized. However, when it comes to a lens made of transparent synthetic resin, i.e., a plastics lens, the conventional Indian ink containing a volatile solvent is not suited for use on the plastics lens because the volatile solvent, selected to be of a type which does not dissolve the synthetic resin used to form the lens, tends to take a relatively long time, for example, more than a few hours, to evaporate. This nature of the selected solvent is in contrast to the purpose for which the plastics lens has been developed and practically adopted, i.e., to increase the productivity of optical devices by employing inexpensive and easy-to-manufacture plastics lenses. On the other hand, the formation of the light shield coating with the use of the conventional black-colored thermosettable paint requires not only the use of a heating furnace, but also the heating furnace to be heated to a temperature not higher than 80°C in the light of the glass transition temperature of acrylic resin, a popular material for the plastics lens, and, therefore, the hardening of the thermosettable paint tends to take a relatively long time, for example, more than a few hours. Moreover, a commercially available black-colored photo-settable paint has a light transmissibility and, therefore, where the light shield coating is desired to be formed, it must be applied repeatedly a number of times, for example, more than five times, to give the multi-layered coating of about 100 micrometers in thickness. In view of this, the conventional photosettable paint of the type referred to above is not suited as a coating material which exhibits a relatively high productivity.

On the other hand, since the plastics lens is continuously manufactured by the use of an injection molding machine, a light shielding coating material capable of forming the light shield coating exteriorly of the plastic lens in a minimized time has long been desired. Moreover, since the plastics lens is mounted in a lens mount or barrel, the light shielding coating material also capable of, when formed into the light shield coating, exhibiting a high light-shielding property with the minimized thickness, for example, ten micrometers, has been desired.

Summary of the Invention

The present invention has for its object to provide a photo-settable, light-shielding coating composition which is suited or use on a plastics lens used in binoculars, cameras, video projectors or television receiver sets and which is high in hardening speed and is effective to result in the excellent light shield coating of uniform layer thickness.

In order to accomplish this object, the present invention provides a photo-settable, light-shielding composition which comprises 1 to 30 wt% of polyacrylate selected from the group consisting of urethane polyacrylate, epoxy polyacrylate, polyester polyacrylate and a mixture thereof, 30 to 70 wt% of acrylate monomer selected from the group consisting of polyacrylate monomer, acrylate monomer and a mixture thereof, 5 to 30 wt% of globular light scattering agent, 5 to 30 wt% of white filler material, 2 to 10 wt% of carbon powder, and 2 to 7 wt% of photosensitizer. If the amount of the polyacrylate used was smaller than 1 wt%, the resultant coating has been found containing cracks, but if it was greater than 30 wt%, the resultant coating has been found soft, lacking a sufficient hardness, and is, therefore, not suited as a coated layer.

With respect to the amount of the acrylate monomer, if it was smaller than 30 wt%, the coating composition prepared tends to have a high viscosity, for example, a few ten thousands centipoises, and can not be used for forming the resultant coating of not greater than 100 micrometers in layer thickness. On the other hand, if it was greater than 70 wt%, it has been found that, during the hardening of the applied composition, the surface hardening of the coating did not give a favorable result.

With respect to the amount of the globular light scattering agent used, if it was smaller than 5 wt%, it has been found not only that a portion of the resultant coating intermediately of the thickness thereof failed to harden satisfactory, but also that the resultant coating peeled off during the continuous test in the atmosphere of 40°C at 90% relative humidity. If it was greater than 30 wt%, the viscosity of the coating composition has increased to a few thousands centipoises and the coating composition become no longer useable although the hardening property of the coating was improved.

With respect to the amount of the carbon powder used, if it was smaller than 2 wt%, the resultant coating has exhibited a poor light shielding property, but if it was greater than 10 wt%, the light shielding property of the resultant coating has been excessively increased, but the resultant coating has been found containing a non-hardened portion interiorly of the coating while the outermost surface thereof was hardened.

Since the light shield coating formed by the use of the composition according to the present invention on the plastics lens is desired to have a thickness of not greater than 100 micrometers, glass beads of not

2

greater than 10 micrometers in particle size are suited as the globular light scattering material and, likewise, the white filler material contains, as its main component, titanium dioxide of not greater than 10 micrometers in particle size.

Detailed Description of the Embodiment

Hereinafter, the present invention will be described in details by way of examples which are not intended to limit the scope of the present invention, but are employed only for the purpose of illustration.

In the practice of the present invention, the polyacrylates employed were polyurethane polyacrylate manufactured and sold by Mitsubishi Yuka Fine Chemical Co., Ltd., of under a trade identification of UV—160P—3, epoxy polyacrylate manufactured and sold by Nippon Kayaku K.K. of Japan under a trade identification of R—146, and polyester polyacrylate manufactured and sold by Toyobo K.K. of Japan. As the acrylate, various monomers such as, for example, dipentaerythritol hexacrylate and neopentadiglycidyl-acrylate may be employed as a substitute for TMPTA (trimethylolpropane triacrylate) and MANDA (polyester diacrylate manufactured and sold by Nippon Kayaku K.K. of Japan), but TMPTA, MANDA and glycidyl methacrylate (GMA) were used for the purpose of illustration of the present invention.

With respect to the light scattering agent, a mixture of glass beads, 1 micrometer in average particle size, and Aerosil (silicon dioxide) in a mixing ratio of 2:1 was used. Although the Aerosil is globular particles having a particle size ranging from tens angstroms to hundreds angstroms, the use of the glass beads, greater in particle size than Aerosil, in a quantity greater than the Aerosil resulted in the coating composition capable of exhibiting a better hardening property than that of the coating composition wherein the both are used in an equal quantity. As the white filler material, talc was employed. The carbon powder may be employed in the form of any suitable carbon, but was used in the form of ketjen black.

These ingredients, employed in respective quantites shown in the Table, were melted and mixed in an oil bath and, thereafter, the mixture was kneaded by the use of three mixing rolls. Though the photosensitizer may be any commercially available photosensitizer, the photosensitizer manufactured and sold by Ciba-Geigy of Switzerland under a trade name "Ingacure 184" in a quantity of 5 wt% was employed in each of the coating compositions listed in the Table.

The photo-settable black coating composition according to the present invention is preferred to have a viscosity within the range of 0.1 to 20 Pa·s (1 to 200 poises) in order for it to be suited for use in coating the plastics lens to form the light shielding coating. In the Table, the compositions having a viscosity falling within this range, within a range of 20 to 50 Pa·s (200 to 500 poises) and in a range higher than 50 Pa·s (500 poises) are marked ○, △ and ×, respectively. The light-shielding coating formed by the use of each of the compositions shown in the Table was subjected to a peeling test according to the method stipulated by JIS (Japanese Industrial Standard) D 0202. This peeling test was conducted by dividing the light-shielding coating into 100 pieces and counting the number of the pieces peeled when an adhesive tape sticking to the coating had been removed. The number of the pieces peeled off is indicated by ○, △ and ×, respectively, when it was 0 to 20, 21 to 50 and more than 50.

Also, the bonding strength of the light-shielding coating of each compositions to an acrylic resin was measured in the atmosphere of 40°C and 90% in relative humidity. The result of the measurement are indicated by ○, △ and × which represent "Good", "Fair" and "Rejected", respectively.

| No. | Urethane UV 160P-3 | Bisphenol-A-epoxy-polyacrylate | Polyester polyacrylate | TMPTA | MANDA | GMA | Glass beads | TiO₂ Talc | Ketjen black | Viscosity | Bonding Strength | Bonding Strength 40°C 90% RH after 200 hours |
|---|---|---|---|---|---|---|---|---|---|---|---|---|
| | | Urethane | | | Acrylic Monomer | | Scattering Agent | Filler | Carbon Powder | | | |
| 1 | 1 | | | 50 | 10 | | 20 | 10 | 4 | o | Δ | Δ |
| 2 | 5 | | | 40 | 15 | | 20 | 10 | 5 | o | o | o |
| 3 | 30 | | | 20 | 5 | 5 | 20 | 10 | 5 | Δ | o | o |
| 4 | | 1 | | 50 | 10 | | 20 | 10 | 4 | o | Δ | Δ |
| 5 | | 5 | | 40 | 15 | | 20 | 10 | 5 | o | o | o |
| 6 | | 30 | | 20 | 5 | 5 | 20 | 10 | 5 | Δ | o | o |
| 7 | | 40 | | 10 | 5 | 5 | 20 | 10 | 5 | x | Δ | Δ |
| 8 | | | 1 | 50 | 10 | | 20 | 10 | 4 | o | Δ | Δ |
| 9 | | | 5 | 40 | 15 | | 20 | 10 | 5 | o | o | o |
| 10 | | | 30 | 20 | 5 | 5 | 20 | 10 | 5 | Δ | o | o |
| 11 | | 5 | | 10 | 20 | | 20 | 10 | 5 | o | o | o |
| 12 | | 5 | | 40 | 20 | | 20 | 10 | 5 | o | o | o |
| 13 | | 2 | | 50 | 20 | | 10 | 10 | 3 | o | o | o |
| 14 | | 5 | | 50 | 20 | | 5 | 10 | 5 | o | o | o |
| 15 | | 5 | | 30 | 15 | | 30 | 10 | 5 | Δ | o | o |
| 16 | | 5 | | 40 | 10 | 5 | 20 | 5 | 5 | o | o | o |
| 17 | | 5 | | 30 | 10 | 5 | 10 | 30 | 5 | Δ | o | o |
| 18 | | 5 | | 40 | 10 | 5 | 20 | 10 | 2 | o | o | o |
| 19 | | 5 | | 40 | 15 | 5 | 10 | 10 | 10 | o | o | o |
| 20 | | 5 | | 30 | 15 | 5 | 10 | 10 | 20 | o | x | x |

(All containing 5 wt % Light Sensitizer)

0 135 925

From the foregoing, it has now become clear that the light-shielding composition according to the present invention is effective to form the light-shielding coating within a minute, when hardened under the radiation of ultraviolet rays.

Although the present invention has fully been described in connection with the preferred embodiment, it should be noted that various changes and modifications are apparent to those skilled in the art. By way of example, although the polyacrylate or the acrylate monomer has been described as used in the composition of the present invention, polymethacrylate or methacrylate monomer may be employed, it being, however, that the hardening speed is somewhat retarded.

Accordingly, such changes and modifications are to be understood as included within the scope of the present invention as defined by the appended claims, unless they depart therefrom.

The trade marks as employed in the above are acknowledged as such.

**Claims**

1. A photo-settable coating composition for forming a black-colored light-shield layer, which comprises 1 to 30 wt% of polyacrylate selected from the group consisting of urethane polyacrylate, epoxy polyacrylate, polyester polyacrylate and a mixture thereof, 30 to 70 wt% of acrylate monomer selected from the group consisting of polyacrylate monomer, acrylate monomer and a mixture thereof, 5 to 30 wt% of globular light-scattering agent, 5 to 30 wt% of white-colored filler material 2 to 10 wt% of carbon powder, and 2 to 7 wt% light sensitizer.

2. A composition as claimed in Claim 1, wherein said light scattering agnet is glass beads having a particle size not greater than 10 micrometers.

3. A composition as claimed in Claim 1, wherein said filler material contains, as its main component, titanium dioxide having a particle size not greater than 10 micrometers.

**Patentansprüche**

1. Fotohärtbare Überzugszusammensetzung zur Bildung einer schwarzgefärbten Lichtschutzschicht, welche 1 bis 30 Gew.-% eines Polyacrylates enthält, das aus der Gruppe ausgewählt ist, die Urethan-Polyacrylat, Epoxy-Polyacrylat, Polyester-Polyacrylat und Mischungen dieser umfaßt, und 30 bis 70 Gew.-% von Acrylatmonomerem enthält, welches aus der Gruppe ausgewählt ist, welche Polyacrylatmonomeres, Acrylatmonomeres und eine Mischung von diesen umfaßt, und welche weiterhin 5 bis 30 Gew.-% eines kugelförmigen Lichtstreumittels, 5 bis 30 Gew.-% eines weißen Füllmaterials, 2 bis 10 Gew.-% Kohlenstoffpulver und 2 bis 7 Gew.-% Licht-Sensibilisator enthält.

2. Überzugszusammensetzung nach Anspruch 1, bei welcher das Lichtstreumittel aus Glasperlen mit einer Teilchengröße von nicht mehr als 10 Mikrometern besteht.

3. Überzugszusammensetzung nach Anspruch 1, bei welcher das Füllmaterial als Hauptbestandteil Titanoxyd mit einer Teilchengröße von nicht mehr als 10 Mikrometern enthält.

**Revendications**

1. Une composition de revêtement photodurcissable pour former une couche photoprotectrice noire, qui comprend 1 à 30% en poids d'un polyacrylate choisi parmi les uréthannes-polyacrylates, les époxy-polyacrylates, les polyesters-polyacrylates et leurs mélanges, 30 à 70% en poids d'un acrylate monomère choisi parmi les polyacrylates monomères, les acrylates monomères et leurs mélanges, 5 à 30% en poids d'un agent globulaire diffractant la lumière, 5 à 30% en poids d'une matière de charge blanche, 2 à 10% en poids de poudre de carbone et 2 à 7% en poids d'un photosensibilisateur.

2. Une composition selon la revendication 1, dans laquelle ledit agent diffractant la lumière consiste en perles de verre ayant une dimension de particules de pas plus de 10 μm.

3. Une composition selon la revendication 1, dans laquelle ladite matière de charge contient comme composant principal du bioxyde de titane ayant une dimension de particules de pas plus de 10 μm.